(19) Europäisches Patentamt
European Patent Office
Office européen des brevets

(11) **EP 1 191 348 B1**

## (12) EUROPÄISCHE PATENTSCHRIFT

(45) Veröffentlichungstag und Bekanntmachung des Hinweises auf die Patenterteilung:
**13.11.2013  Patentblatt 2013/46**

(51) Int Cl.:
*G01S 7/527* (2006.01)   *G01S 7/526* (2006.01)
*H03F 3/72* (2006.01)   *H03F 3/45* (2006.01)

(21) Anmeldenummer: **01120209.0**

(22) Anmeldetag: **23.08.2001**

(54) **Schaltungsanordnung zur umschaltbaren Verstärkung von Analogsignalen**

Circuit arrangement for switchable amplification of analogue signals

Circuit pour l'amplification commutable de signaux analogues

(84) Benannte Vertragsstaaten:
**AT BE CH CY DE DK ES FI FR GB GR IE IT LI LU MC NL PT SE TR**

(30) Priorität: **26.09.2000  DE 10047396**

(43) Veröffentlichungstag der Anmeldung:
**27.03.2002  Patentblatt 2002/13**

(73) Patentinhaber: **ATLAS ELEKTRONIK GmbH
28305 Bremen (DE)**

(72) Erfinder: **Wittschief, Norbert
28832 Achim (DE)**

(56) Entgegenhaltungen:
**US-A- 4 016 557**

**Beschreibung**

Die Erfindung betrifft eine Schaltungsanordnung zur in diskreten Stufen umschaltbaren Verstärkung von Analogsignalen, insbesondere von Ausgangssignalen der Hydrophone einer Sonarbasis.

Schaltungsanordnungen dieser Art dienen bei Sonaranlagen zur Verstärkung der Hydrophonausgangssignale, um für die anschließende, digitale Signalverarbeitung einen angepaßten Signalpegel zur Verfügung zu haben. Hierzu sind die Ausgänge eines jeden Hydrophons der Sonarbasis an einem Ladungsverstärker angeschlossen, und die elektrischen Ausgangssignale der beiden Ladungsverstärker sind der Schaltungsanordnung zugeführt. Eine bekannte Schaltungsanordnung dieser Art wird als Bauteil AD 7111 von der Firma Analog Devices, USA, am Markt angeboten. Sie weist im wesentlichen einen nicht invertierenden Operations- oder Rechenverstärker auf, dessen Gegenkopplungs- oder Rückkopplungswiderstand in diskreten Widerstandsstufen umschaltbar ist. Bei Sonaranlagen ist es wesentlich, daß in den vielen parallelen Signalverarbeitungskanälen annähernd gleiche Verhältnisse vorliegen, d.h. die Amplitudenabweichung und die Phasenabweichung zwischen den verstärkten Hydrophonausgangssignalen müssen möglichst gering sein. Aufgrund der Exemplarstreuungen des AD 7111 ist dies nur in Grenzen gewährleistet.

Bei einer bekannten Schaltungsanordnung (FR 2 310 655 A1 bzw. US 4 016 557) weist die symmetrische Schaltungsstufe, dort Differenzverstärker genannt, zwei nichtinvertierende Operationsverstärker mit jeweils einem invertierenden und einem nicht invertierenden Eingang, einem Ausgang und einem die Verstärkung des Operationsverstärkers bestimmenden, in Stufen veränderlichen Rückkopplungswiderstand auf. Die beiden nichtinvertierenden Eingänge der Operationsverstärker sind mit einem Differentialsignal belegt, das am Ausgang des Differenzverstärkers entsprechend verstärkt abgenommen werden kann. Die Verstärkung des Differenzverstärkers ist in Stufen nach Wahl einstellbar. Hierzu besteht jeder der veränderlichen Rückkopplungswiderstände der Operationsverstärker aus einer an den Ausgang des Operationsverstärkers angeschlossenen Reihenschaltung von mehreren Widerständen, deren Widerstandswerte zunehmen. Mittels einer Mehrzahl von Halbleiterschaltern sind die Widerstände einzeln oder in Gruppen an den invertierenden Eingang des Operationsverstärker anschließbar. Durch symmetrische Ansteuerung der Halbleiterschalter in den beiden Rückkopplungszweigen der beiden Operationsverstärker ist eine gleiche Verstärkung beider Operationsverstärker einstellbar. Die beiden Reihenschaltungen sind noch über einen Widerstand miteinander gekoppelt.

Der Erfindung liegt die Aufgabe zugrunde, eine Schaltungsanordnung der eingangs genannten Art zu konzipieren, deren Verstärkung in einem großen Verstärkungsbereich in vorzugsweise kleinen Verstärkungsstufen umschaltbar ist, eine auf sehr geringe Amplituden- und Phasenabweichungen eingeschränkte Exemplarstreuung zeigt und nach Verstärkungsumschaltung eine nur kurze Einschwingzeit benötigt.

Die Aufgabe ist erfindungsgemäß durch die Merkmale im Anspruch 1 gelöst.

Die erfindungsgemäße Schaltungsanordnung hat den Vorteil, daß durch das neuartige Schaltungskonzept die Gegen- oder Rückkopplungswiderstände der beiden Operationsverstärker relativ niederohmig (im Kiloohmbereich) ausgeführt werden können und dadurch die Schaltungsanordnung eine hohe Präzision aufweist. Die Eigenschaften der Schaltungsanordnung werden im wesentlichen durch die Widerstände bestimmt, und die Restwiderstände der vorzugsweise als Halbleiterschalter verwendeten MOS-Switches spielen eine untergeordnete Rolle. Da die Bauteiltoleranzen der am Markt erhältlichen Widerstände kleiner als 0,1 % ist, im Gegensatz zu einer Bauteiltoleranz bei Halbleiterschaltern von ca. 1 %, ist die Exemplarstreuung der Schaltungsanordnung extrem gering. Die aufgrund der Exemplarstreuungen auftretenden Amplitudenabweichungen liegen bei 0,1 dB und die Phasenabweichungen bei 0,2°. Die Möglichkeit der niederohmigen Bemessung der für die Verstärkung maßgebenden Widerstände ist dadurch begründet, daß durch den symmetrischen Aufbau der Schaltungsstufe und der annähernd gleichen Bemessung der Schaltwiderstände bei geschlossenem MOS-Switch an diesem eine Signalspannung von ungefähr 0V liegt. Bei einer Signalspannung von ungefähr 0V arbeitet der MOS-Switch, wie z.B. der ADG 511 der Firma One Technology Way, Norwood, USA, einerseits niederohmig und andererseits mit extrem geringer Exemplarstreuung. Außerdem wird für jeden Operationsverstärker der in Reihe mit den Schaltwiderständen liegende, niederohmige Restwiderstand $R_{ON}$ des MOS-Switch noch zusätzlich halbiert. Dies ermöglicht insgesamt eine niederohmige Auslegung der Schaltwiderstände, was zur Folge hat, daß bei unveränderter Verstärkung auch die Gegen- oder Rückkopplungswiderstände der Operationsverstärker niederohmig ausgeführt werden können, deren Widerstandswerte nunmehr aus dem MΩ-Bereich gemäß dem Stand der Technik in den kΩ-Bereich verlegt werden können. Von dem Idealfall der exakt gleichen Bemessung der Schaltwiderstände kann in von den Frequenzen der zu verstärkenden Signalen abhängigen Grenzen abgewichen werden, da sich der Restwiderstand $R_{ON}$ des MOS-Switch bei einer Signalspannung um die 0V herum nur wenig ändert. Die Abweichung von der gleichen Bemessung der Schaltwiderstände kann beispielsweise für die Verstärkung von Analogsignalen bis zu 10 kHz einige 100 Ω betragen.

Durch die Symmetrie der Schaltungsstufe werden zudem nur Differenzspannungen der Analogsignale verstärkt, so daß eingestreute Störungen sich kompensieren und sich nicht auf die verstärkte Signalspannung auswirken können.

Zweckmäßige Ausführungsformen der erfindungsgemäßen Schaltungsanordnung mit vorteilhaften Weiterbildungen und Ausgestaltungen der Erfindung ergeben sich aus den weiteren Ansprüchen.

Gemäß einer vorteilhaften Ausführungsform der Erfindung ist an jedem Ausgang der Operationsverstärker ein gegen Masse geschalteter Spannungsteiler über einen Koppelkondesator angeschlossen. Alle Widerstände der beiden Spannungsteiler sind gleich groß bemessen, und an je einem Teilerabgriff der Spannungsteiler ist das verstärkte Analogsignal und das um 180° phasenverschobene verstärkte Analogsignal abnehmbar. Durch diese Spannungsteiler ist einerseits auch die Verstärkung "1" in der Schaltungsstufe darstellbar und andererseits bei geeigneter Bemessung der Widerstände eine für die Operationsverstärker optimal angepaßte Last sichergestellt.

Gemäß einer bevorzugten Ausführungsform der Erfindung weist die symmetrische Schaltungsstufe einen weiteren Halbleiterschalter, vorzugsweise einen MOS-Switch, mit zwei Schaltereingängen auf, von denen jeder über einen Widerstand an einem der Teilerabgriffe der beiden Spannungsteiler angeschlossen ist. Die Widerstände sind in Toleranzgrenzen gleich groß, vorzugsweise exakt gleich groß, bemessen, wobei zu den Toleranzgrenzen die vorstehenden Ausführungen zu dem ersten MOS-Switch in gleicher Weise gelten. Mit diesem zusätzlichen MOS-Switch wird nach dem Prinzip des Spannungsteilers eine kleine Verstärkung realisiert, d.h. die durch die Operationsverstärker erreichte Verstärkung wieder reduziert. Die Größe der Dämpfung richtet sich dabei nach der Bemessung des zwischen dem Teilerabgriff und dem MOS-Switch liegenden Widerstands, der zusammen mit den Widerständen des Spannungsteilers den für die Dämpfung maßgebenden Spannungsteiler darstellt.

Gemäß einer vorteilhaften Ausführungsform der Erfindung werden mehrere symmetrischen Schaltungsstufen hintereinander geschaltet, indem die Teilerabgriffe der Spannungsteiler in der vorhergehenden Schaltungsstufe mit den nichtinvertierenden Eingängen der Operationsverstärker der folgenden Schaltungsstufen verbunden werden. Durch entsprechende Ausbildung der Verstärkung in den einzelnen Schaltungsstufen kann ein großer Verstärkungsbereich in relativ kleinen Verstärkungsschritten umgeschaltet werden, so  z.B. bei insgesamt vier Schaltungsstufen ein Verstärkungsbereich von 0 - 72 dB in 192 diskreten Schritten mit einer Verstärkungszu- oder -abnahme von jeweils 0,375 dB.

Die Erfindung ist anhand eines in der Zeichnung dargestellten Ausführungsbeispiels im folgenden näher beschrieben. Es zeigen:

Fig. 1    ein schematisches Schaltbild einer Schaltungsanordnung zur umschaltbaren Verstärkung von Analogsignalen in diskreten Stufen mit insgesamt vier hintereinander geschalteten Schaltungsstufen,

Fig. 2    ein Schaltbild einer der Schaltungsstufe der Schaltungsanordnung in Fig. 1.

Beschreibung des Ausführungsbeispiels

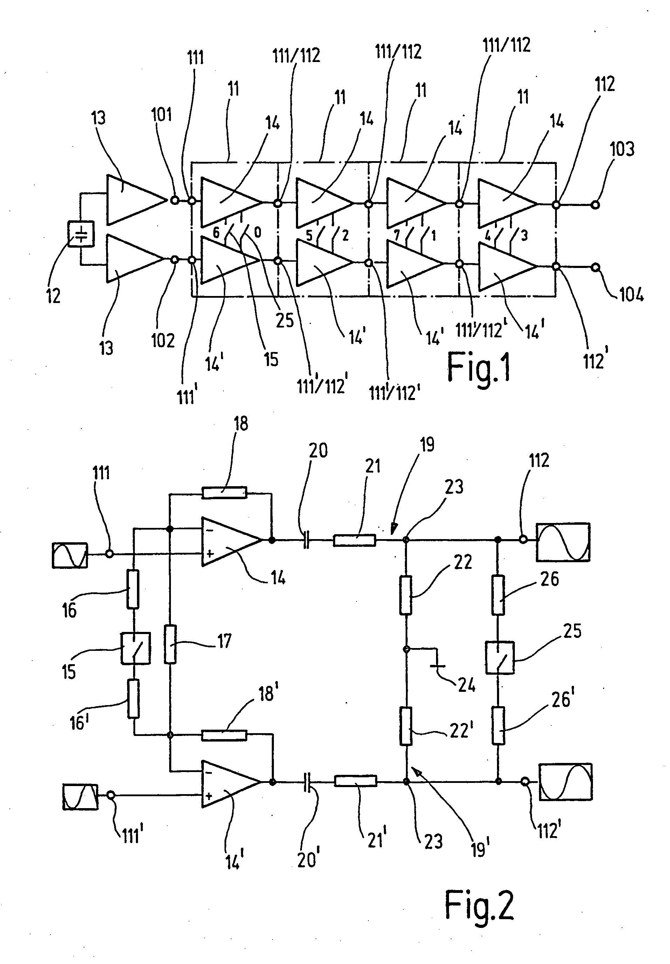

Bei der in Fig. 1 skizzierten Schaltungsanordnung zur umschaltbaren Verstärkung von Analogsignalen in diskreten Stufen sind insgesamt vier in gleicher Weise konzipierte Schaltungsstufen 11 hintereinander geschaltet, wobei jede Schaltungsstufe 11 über zwei Bit-Eingänge digital umgeschaltet werden kann. Mit insgesamt 192 Umschaltmöglichkeiten werden in einem Verstärkungsbereich von 0 - 72 dB Verstärkungsänderungen in diskreten Stufen von 0,375 dB realisiert. Die zu verstärkenden Analogsignale werden dabei den Eingängen 101 und 102 der Schaltungsanordnung zugeführt und die verstärkten Analogsignale an den Ausgängen 103 und 104 der Schaltungsanordnung abgenommen. Beim Einsatz in Sonaranlagen zur Verstärkung der Ausgangssignale der in einer Sonarbasis  angeordneten Vielzahl von Hydrophonen 12, sind die beiden Ausgänge eines jeden Hydrophons 12 an je einem Ladungsverstärker 13, 13' angeschlossen, wobei der Ausgang des einen Ladungsverstärkers 13 mit dem Eingang 101 der Schaltungsanordnung und der Ausgang des anderen Ladungsverstärkers 13' an dem Eingang 102 der Schaltungsanordnung liegt. Die beiden Ladungsverstärker 13, 13' sind identisch aufgebaut. Die verstärkten Hydrophonausgangssignale werden - wie in Fig. 1 nicht weiter dargestellt ist - über die Ausgänge 103 und 104 der Schaltungsanordnung je einem Analog-Digital-Wandler mit vorgeschaltetem Anpaßverstärker zugeführt.

In Fig. 2 ist eine der Schaltungsstufen 11 detailliert im Schaltbild dargestellt. Die Eingänge der symmetrisch aufgebauten Schaltungsstufe 11 sind mit 111 und 111' und die Ausgänge der Schaltungsstufe 11 mit 112 und 112' bezeichnet. Die Ausgänge 112 bzw. 112' der einen Schaltungsstufe 11 sind mit den Eingängen 111, 111' der folgenden Schaltungsstufe verbunden. Die Eingänge 111 und 111' der ersten Schaltungsstufe bilden die Eingänge 101 und 102 der Schaltungsanordnung und die Ausgänge 112 und 112' der letzten Schaltungsstufe 11 bilden die Ausgänge 103 und 104 der Schaltungsanordnung. Am Eingang 111 liegt das zu verstärkende Analogsignal und am Eingang 111' liegt das zu verstärkende Analogsignal um 180° phasenverschoben an, wie dies in Fig. 2 symbolisch angedeutet ist. Am Ausgang 112 ist das verstärkte Analogsignal und am Ausgang 112' das um 180° phasenverschobene, verstärkte Ausgangssignal abnehmbar, wobei diese Analogsignale der nächsten Schaltungsstufe 11 zugeführt werden.

Die Schaltungsstufe 11 weist zwei nichtinvertierende Rechen- oder Operationsverstärker 14, 14' sowie einen Halbleiterschalter, bevorzugt einen MOS-Switch 15, mit zwei Schaltereingängen auf, der digital geschlossen oder geöffnet wird. Als ein solcher MOS-Switch 15 werden beispielsweise die monolithischen CMOS-ICs ADG 511, ADG 512 oder ADG 513 der Firma One Technology Way, Norwood, USA eingesetzt. Der eine Schaltereingang des MOS-Switch 15 ist über einen Schaltwiderstand 16 mit dem invertierenden Eingang oder Minuseingang des Operationsverstärkers 14 und der andere Schaltereingang des MOS-Switch 15 über einen Schaltwiderstand 16' an den invertierenden oder Minuseingang des Operationsverstärkers 14' angeschlossen. Parallel zu der Reihenschaltung der beiden Schaltwiderstände 16, 16' und des MOS-Switch 15 ist ein Zwischenwiderstand 17 geschaltet. Der nichtinvertierende Eingang oder Pluseingang des Operationsverstärkers 14 ist mit dem Eingang 111 und der nichtinvertierende Eingang oder Pluseingang des Operationsverstärkers 14' ist mit dem Eingang 111' der Schaltungsstufe 11 verbunden.

Jeder der beiden nichtinvertierenden Operationsverstärker 14, 14' weist in bekannter Weise einen Gegen- oder Rückkopplungswiderstand 18 bzw. 18' auf. Beide Rückkopplungswiderstände 18, 18' sind gleich groß und entsprechend der gewünschten Verstärkung bemessen. Ggf. kann dem Rückkopplungswiderstand 18, 18' ein Kondensator parallelgeschaltet sein. Die beiden Schaltwiderstände 16, 16' sind gleich groß bemessen, wobei die Widerstandswerte im $k\Omega$-Bereich liegen und Abweichungen von der identischen Bemessung von einigen 100 $\Omega$ zulässig sind, ohne daß die Präzision der Schaltungsstufe 11 beeinträchtigt wird.

Bei geöffnetem MOS-Switch 15 beträgt die Verstärkung V eines jeden Operationsverstärkers 14, 14'

$$V \; = \; \frac{R_{18}}{\frac{1}{2} \, R_{17}} \; + \; 1 \qquad\qquad (1) \, ,$$

wobei $R_{18}$ der Widerstandswert des Rückkopplungswiderstandes 18 bzw. 18' und $R_{17}$ der Widerstandswert des Zwischenwiderstands 17 ist. Bei geschlossenem MOS-Switch 15 ergibt sich die Verstärkung der Operationsverstärker 14, 14' jeweils zu

$$V \; = \; \frac{R_{18}}{R_{ges}} \; + \; 1 \qquad\qquad (2)$$

mit

$$R_{ges} \; = \; \frac{\frac{1}{2} \, R_{17} \left( R_{16} \; + \; \frac{1}{2} \, R_{ON} \right)}{\frac{1}{2} \, R_{17} \; + \; R_{16} \; + \; \frac{1}{2} \, R_{ON}} \qquad\qquad (3) \, ,$$

wobei $R_{16}$ der Widerstandswert des Schaltwiderstandes 16 bzw. 16' und $R_{ON}$ der Restwiderstand des MOS-Switch 15 ist. Da durch die annähernd gleiche Bemessung der Schaltwiderstände 16, 16' die Signalspannung am geschlossenen MOS-Switch 15 etwa Null ist, ist der Restwiderstand $R_{ON}$ minimiert und beträgt bei Verwendung eines ADG 511 bei Raumtemperatur etwa 18 $\Omega$. Da im Bereich einer Signalspannung von $\pm$ 1 V der Restwiderstand $R_{ON}$ des ADG 511 nur gering anwächst, ist die erwähnte Abweichung von der identischen Bemessung der Widerstandswerte der Schaltwiderstände 16, 16' akzeptabel. Da die Schaltungsstufe 11 symmetrisch aufgebaut ist, wird der Restwiderstand $R_{ON}$ auf beide Operationsverstärker 14, 14' aufgeteilt und damit zusätzlich halbiert, so daß er für jeden Operationsverstärker 14, 14' nur noch mit ca. 9 $\Omega$ wirksam ist. Aufgrund dieses niedrigen Restwiderstandes $R_{ON}$ können die Schaltwiderstände 16, 16' niederohmig ausgelegt werden, als Folge dessen auch die Rückkopplungswiderstände 18, 18' bei unveränderter Verstärkung niederohmig gemacht werden können. Die niederohmige Beschaltung der Operationsverstärker 14, 14' ist entscheidend für die Präzision dieser Verstärker.

An dem Ausgang eines jeden Operationsverstärkers 14, 14' ist ein Spannungsteiler 19, 19' über einen Kopplungskondensator 20, 20' angeschlossen. Die beiden Spannungsteiler 19, 19' sind auf Massepotential gelegt. Jeder Spannungsteiler 19, 19' weist einen kondensatorseitigen Widerstand 21 bzw. 21' und einen masseseitigen Widerstand 22 bzw. 22' auf. Der Teilerabgriff des Spannungsteilers 19 bzw. 19' ist mit 23 bzw. 23' bezeichnet. Die beiden Widerstände 21, 22 bzw. 21', 22' der Spannungsteiler 19, 19' sind gleich groß bemessen, und wegen der symmetrischen Ausbildung der Schaltungsstufe 11 sind auch die Widerstände in dem Spannungsteiler 19 gleich den Widerständen in dem Spannungsteiler 19' bemessen. Die Bemessung der Widerstände 21, 22, 21', 22' ist dabei so festgelegt, daß die Operationsverstärker 14, 14' eine optimal angepaßte Last besitzen, typischerweise bei Verwendung eines ADG 511 in Verbindung mit dem OP467 der Firma Analog Devices, als Operationsverstärker 14, 14' um 3 bis 3,5 kΩ. Jeder Spannungsteiler 19, 19' bewirkt einerseits eine Reduzierung der durch den vorgeschalteten Operationsverstärker 14, 14' gewonnenen Verstärkung und ermöglicht andererseits eine Verstärkung von "1" bei geöffnetem MOS-Switch 15. Wird beispielsweise mit dem Operationsverstärker 14 bzw. 14' eine Verstärkung von 30 dB erreicht, so wird diese durch den Spannungsteiler 19, 19' beispielsweise um 6 dB gedämpft, so daß an den Teilerabgriffen 23, 23' der Spannungsteiler 19, 19' eine Spannungsverstärkung von 24 dB erreicht wird.

Die Schaltungsstufe 11 weist noch einen zweiten, ebenfalls als MOS-Switch 25 ausgebildeten Halbleiterschalter auf, für den ebenfalls ein ADG 511 verwendet werden kann. Jeweils ein Schaltereingang des zweiten MOS-Switch 25 ist über einen Schaltwiderstand 26 an dem Teilerabgriff 23 des Spannungsteilers 19 und über einen Schaltwiderstand 26' an dem Teilerabgriff 23' des Spannungsteilers 19' angeschlossen. Die Schaltwiderstände 26, 26' sind wiederum gleich groß bemessen, wobei die gleichen Abweichungsgrenzen gelten, wie sie zu den Schaltwiderständen 16 und 16' vorstehend beschrieben worden sind. Wird der MOS-Switch 25 geschlossen, so wird die Verstärkung der Schaltungsstufe 11 je nach Auslegung der Schaltwiderstände 26, 26' um einen bestimmten Betrag angehoben oder weiter abgesenkt, da sich nunmehr die über die Kopplungskondensatoren 20, 20' angeschlossenen Spannungsteiler aus dem kondensatorseitigen Widerstand 21 bzw. 21' und aus der Parallelschaltung der Widerstände 22, 26 bzw. 22', 26' zusammensetzen.

Die beiden MOS-Switch 15, 25 in jeder Schaltungsstufe 11 werden digital durch Anlegen eines entsprechenden Bitformats gesteuert. Dies ist in Fig. 1 durch die beiden, die Operationsverstärker 14 und 14' miteinander verbindenden, symbolischen Schalter angedeutet. Das den jeweiligen Schalter steuernde Bit ist mit seiner Bitzahl in der Bitfolge dem jeweiligen MOS-Switch 15 bzw. 25 symbolisch zugeordnet. So wird die erste Schaltungsstufe 11 von dem Bit 6 und 0 und die folgende Schaltstufe von dem Bit 5 und dem Bit 2 der Bitfolge angesteuert. Je nach Öffnen und Schließen der MOS-Switches 15 und MOS-Switches 25 in den vier Schaltungsstufen der Fig. 1 können insgesamt $2^8$ diskrete Verstärkerstufen umgeschaltet werden, von denen für den Verstärkungsbereich 0 - 72 dB 192 Verstärkerstufen genutzt werden.

## Patentansprüche

1.  Schaltungsanordnung zur in diskreten Stufen umschaltbaren Verstärkung von Analogsignalen, insbesondere von Ausgangssignalen der Hydrophone einer Sonarbasis, mit mindestens einer symmetrischen Schaltungsstufe (11), die zwei nichtinvertierende Operationsverstärker (14, 14') mit jeweils einem invertierenden und einem nichtinvertierenden Eingang, einem Ausgang und einem zwischen Ausgang und invertierendem Eingang vorhandenen Rückcopplungswiderstand (18, 18') sowie mindestens einen Halbleiterschalter (15) mit zwei Schaltereingängen aufweist, **dadurch gekennzeichnet, dass** der nichtinvertierende Eingang des einen Operationsverstärkers (14) mit einem Analogsignal und der nichtinvertierende Eingang des anderen Operationsverstärkers (14') mit dem um 180° phasenverschobenen Analogsignal beaufschlagt ist, dass der eine Schaltereingang des Halbleiterschalters (15) über einen ersten Schaltwiderstand (16) mit dem invertierenden Eingang des einen Operationsverstärkers (14) und der andere Schaltereingang des Halbleiterschalters (15) über einen in Toleranzgrenzen gleich großen, vorzugsweise exakt gleich großen, zweiten Schaltwiderstand (16') mit dem invertierenden Eingang des anderen Operationsverstärkers (14') verbunden ist, und dass der Reihenschaltung aus den Schaltwiderständen (16, 16') und dem Halbleiterschalter (15) ein Zwischenwiderstand (17) parallelgeschaltet ist.

2.  Schaltungsanordnung nach Anspruch 1, **dadurch gekennzeichnet, daß** an jedem Ausgang der Operationsverstärker (14, 14') ein gegen Masse (24) geschalteter Spannungsteiler (19, 19') über einen Kopplungskondensator (20, 20') angeschlossen ist, daß alle Widerstände der beiden Spannungsteiler (19, 19') gleich groß bemessen sind und daß an je einem Teilerabgriff (23, 23') der Spannungsteiler (19,19') das verstärkte Analogsignal und das verstärkte phasenverschobene Analogsignal abgenommen sind.

3.  Schaltungsanordnung nach Anspruch 2, **dadurch gekennzeichnet, daß** die symmetrische Schaltungsstufe (11) einen weiteren Halbleiterschalter mit zwei Schaltereingängen aufweist, von denen jeder über einen Schaltwiderstand (26, 26') an einem der Teilerabgriffe (23, 23') der beiden Spannungsteiler (19, 19') angeschlossen ist, und daß die Schaltwiderstände (26, 26') in Toleranzgrenzen gleich groß, vorzugsweise exakt gleich groß, bemessen sind.

4.  Schaltungsanordnung nach Anspruch 2 oder 3, **dadurch gekennzeichnet, daß** mehrere symmetrische Schaltungsstufen (11) hintereinander geschaltet sind, indem die Teilerabgriffe (23, 23') der vorhergehenden Schaltungsstufe (11) mit den nichtinvertierenden Eingängen (Pluseingängen) der Operationsverstärker (14, 14') der folgenden Schaltungsstufe (11) verbunden sind.

**5.** Schaltungsanordnung nach Anspruch 4, **dadurch gekennzeichnet, daß** die der ersten symmetrischen Schaltungsstufe (11) zugeführten Analogsignale die elektrischen Ausgangssignale zweier Ladungsverstärker (13, 13') sind, deren Eingänge mit je einem Ausgang eines Hydrophons (12) verbunden sind.

**6.** Schaltungsanordnung nach einem der Ansprüche 1 bis 5, **dadurch gekennzeichnet, daß** die Halbleiterschalter digital umschaltbar sind.

**7.** Schaltungsanordnung nach einem der Ansprüche 1 bis 6, **dadurch gekennzeichnet, dass** als Halbleiterschalter MOS-Switches (15, 15') eingesetzt sind.

## Claims

**1.** A circuit arrangement for switchable amplification of analogue signals in discrete steps, in particular of output signals of the hydrophone of a sonar base, having at least one symmetrical switching step (11) that has two non-inverting operational amplifiers (14, 14') each having an inverting and a non-inverting input, an output, and a feedback loop (18, 18') provided between output and inverting input, as well as at least one semiconductor switch (15) having two switch inputs, **characterised in that** the non-inverting input of the one operational amplifier (14) is impinged upon by an analogue signal, and the non-inverting input of the other operational amplifier (14') is impinged upon by the analogue signal phase-shifted by 180°, and furthermore **in that** the one switch input of the semiconductor switch (15) is connected via a first switch resistor (16) to the inverting input of the one operational amplifier (14), and the other switch input of the semiconductor switch (15) is connected to the inverting input of the other operational amplifier (14') via a second switch resistor (16') having the same, preferably exactly the same, tolerance limits, and moreover **in that** an intermediate resistor (17) is connected in parallel to the series connection of the switch resistors (16, 16') and the semiconductor switch (15).

**2.** The circuit arrangement according to claim 1, **characterised in that** a voltage divider (19, 19') connected to earth (24) is connected to each output of the operational amplifier (14, 14') via a coupling capacitor (20, 20'), **in that** all resistances of both voltage dividers (19, 19') are the same, and **in that** the amplified analogue signal and the amplified phase-shifted analogue signal are each taken from a divider tap of the voltage dividers (19, 19').

**3.** The circuit arrangement according to claim 2, **characterised in that** the symmetrical switching step (11) has an additional semiconductor switch having two switch inputs, from which each is connected to one of the divider taps (23, 23') of both of the voltage dividers (19, 19') via a switch resistor (26, 26'), and **in that** the switch resistors (26, 26') are the same within tolerance limits, preferably exactly the same.

**4.** The circuit arrangement according to claim 2 or claim 3, **characterised in that** a plurality of symmetrical switching steps (11) are connected in series **in that** the divider taps (23, 23') of the preceding switching step (11) are connected to the non-inverting inputs (positive inputs) of the operational amplifier (14, 14') of the next switching step (11).

**5.** The circuit arrangement according to claim 4, **characterised in that** the analogue signals supplied to the first symmetrical switching step (11) are the electrical output signals of two charge amplifiers (13, 13'), the inputs of which are connected to one output of a hydrophone (12) apiece.

**6.** The circuit arrangement according to any one of claims 1 to 5, **characterised in that** the semiconductor switches are digitally switchable.

**7.** The circuit arrangement according to any one of claims 1 to 6, **characterised in that** MOS switches (15, 15') are used as semiconductor switches.

## Revendications

**1.** Circuit pour l'amplification commutable de signaux analogiques par paliers discrets, en particulier de signaux de sortie des hydrophones d'une base sonar, comprenant au moins un étage de circuit (11) symétrique, qui présente deux amplificateurs opérationnels (14, 14') non inverseurs avec respectivement une entrée inverseuse et une entrée non inverseuse, une sortie et une résistance de rétroaction (18, 18') disposée entre la sortie et l'entrée inverseuse ainsi qu'au moins un interrupteur à semi-conducteurs (15) avec deux entrées d'interrupteur, **caractérisé en ce qu'**un signal analogique est appliqué à l'entrée non inverseuse de l'un des amplificateurs opérationnels (14) et le signal analogique déphasé de 180° est appliqué à l'entrée non inverseuse de l'autre amplificateur opérationnel (14'), **en ce que** l'une des entrées d'interrupteur de l'interrupteur à semi-conducteurs (15) est connectée à l'entrée inverseuse dudit un amplificateur opérationnel (14) via une première résistance (16) et l'autre entrée d'interrupteur de l'interrupteur à semi-conducteurs (15) à l'entrée inverseuse de l'autre amplificateur opérationnel (14') via une seconde résistance (16') de même grandeur dans des limites de tolérance, de préférence exactement de même grandeur, et **en ce qu'**une résistance intermédiaire (17) est branchée en parallèle au montage en série constitué des résistances (16, 16') et de l'interrupteur à semi-conducteurs (15).

2. Circuit selon la revendication 1, **caractérisé en ce qu'**un diviseur de tension (19, 19') connecté à la masse (24) est raccordé via un condensateur de couplage (20, 20') à chaque sortie des amplificateurs opérationnels (14, 14'), **en ce que** toutes les résistances des deux diviseurs de tension (19, 19') sont dimensionnées de même grandeur et **en ce que** le signal analogique amplifié et le signal analogique déphasé amplifié sont prélevés respectivement à un branchement de diviseur (23, 23') des diviseurs de tension (19, 19').

3. Circuit selon la revendication 2, **caractérisé en ce que** l'étage de circuit (11) symétrique présente un autre interrupteur à semi-conducteurs avec deux entrées d'interrupteur, dont chacune est raccordée à l'un des branchements de diviseur (23, 23') des deux diviseurs de tension (19, 19') via une résistance (26, 26'), et **en ce que** les résistances (26, 26') sont dimensionnées de même grandeur dans des limites de tolérance, de préférence exactement de même grandeur.

4. Circuit selon la revendication 2 ou 3, **caractérisé en ce que** plusieurs étages de circuit (11) symétriques sont branchés les uns derrière les autres, du fait que les branchements de diviseur (23, 23') de l'étage de circuit (11) précédent sont connectés aux entrées non inverseuses (entrées positives) des amplificateurs opérationnels (14, 14') de l'étage de circuit (11) suivant.

5. Circuit selon la revendication 4, **caractérisé en ce que** les signaux analogiques entrant dans le premier étage de circuit (11) symétrique sont les signaux électriques de sortie de deux amplificateurs de charge (13, 13') dont les entrées sont connectées respectivement à une sortie d'un hydrophone (12).

6. Circuit selon l'une des revendications 1 à 5, **caractérisé en ce que** les interrupteurs à semi-conducteurs sont commutables de manière numérique.

7. Circuit selon l'une des revendications 1 à 6, **caractérisé en ce que** des commutateurs MOS (15, 15') sont utilisés en tant qu'interrupteurs à semi-conducteurs.

Fig.1

Fig.2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- FR 2310655 A1
- US 4016557 A